Europäisches Patentamt

European Patent Office

Office européen des brevets

(19)

(11) Publication number: **0 209 794**
A2

(12) # EUROPEAN PATENT APPLICATION

(21) Application number: 86109353.2

(22) Date of filing: 09.07.86

(51) Int. Cl.⁴: **H 01 L 21/60**
**H 01 L 21/28**

(30) Priority: 10.07.85 JP 151535/85

(43) Date of publication of application:
28.01.87 Bulletin 87/5

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Ema, Taiji c/o Fujitsu Limited Patent
Department
Kosugi Fujitsu Building 1812-10 Shimonumabe
Nakahara-ku Kawasaki-shi Kanagawa 211(JP)

(74) Representative: Sunderland, James Harry et al,
HASELTINE LAKE & CO Hazlitt House 28 Southampton
Buildings Chancery Lane
London WC2A 1AT(GB)

(54) Method for producing a contact for a semiconductor device.

(57) A method of producing a semiconductor device comprises the steps of forming a field insulating layer (12) and at least two gate insulating layers (13a, 13b) on a semiconductor substrate (11), where the gate insulating layers (13a, 13b) are formed at at least two locations on the semiconductor substrate (11), forming a first conductive layer (21) so as to cover the field insulating layer (12) and the gate insulating layers (13a, 13b), patterning the first conductive layer and one of the gate insulating layers (13a) so as to form a contact hole (22) in which a surface of the semiconductor substrate (11) is exposed, forming a second conductive layer (23) so as to cover the contact hole (22) and the first conductive layer (13a), and patterning the first and second conductive layers (21, 23) so as to form a gate electrode and wiring extending on another (13b) of the gate insulating layers. This other gate insulating layer (13b) is protected by the first conductor layer (21) which covers this other gate insulating layer when the contact hole (22) is formed.

FIG.3C

METHOD OF PRODUCING SEMICONDUCTOR DEVICE

The present invention generally relates to methods of producing semiconductor devices, and more particularly to a method of producing a semiconductor device in which a contact is established between a substrate and a gate electrode and wiring formed on the substrate.

Generally, in a semiconductor integrated circuit and especially in a memory cell of a static random access memory (SRAM), for example, a contact is often established between a gate electrode and wiring (conductive layer) and a source or drain (substrate) of a transistor which is isolated by a field insulating layer. In order to establish the contact between the conductive layer and the substrate, a contact hole is formed in a gate insulating layer and the conductive layer is formed to cover the contact hole during the production process.

However, a resist layer which is used to form the contact hole is removed by use of oxygen ($O_2$) plasma or by use of a mixed fluid comprising sulfuric acid and hydrogen peroxide. When the $O_2$ plasma or the mixed fluid is used to remove the resist layer, a natural oxide layer is inevitably formed on a portion of the substrate exposed to the outside via the contact hole. In addition, while the substrate is stored between processes, a natural oxide layer is formed on the portion of the substrate exposed to the atmosphere via the contact hole. When the natural oxide layer is formed on the substrate at the contact hole, it is impossible to establish a satisfactory contact between the conductive layer and the substrate.

Accordingly, when producing the semiconductor device, it is necessary to provide a process of removing the natural oxide layer between a process of forming the contact hole and a process of forming the conductive layer, in order to establish a satisfactory contact between the conductive layer and the substrate.

According to the conventional method of producing the semiconductor device, the natural oxide layer exposed at the contact hole is removed by an etching process, as will be described later on in the present specification in conjunction with the drawings. However, when the natural oxide layer is etched, the surface of the gate insulating layer is also etched. When the gate insulating layer is etched, there is a disadvantage in that the dielectric strength becomes poor. In addition to the fact that the thickness of the gate insulating layer becomes small due to the etching, it can be regarded that the dielectric strength becomes poor because of a phenomenon wherein defective portions within the gate insulating layer become exposed by the etching and the gate insulating layer is consequently etched unevenly (that is, etched deeply in part). For example, this phenomenon can be confirmed from the fact that when dielectric strength histograms are obtained for first group of insulating layers which have not been etched and second group of insulating layers which have the same thickness as the insulating layers of the first group but have been etched, the dielectric strength of the insulating layers of the second group is deteriorated compared to that of the the insulating layers of the first group.

On the other hand, when the etching is not performed extensively so as to prevent the deterioration of the dielectric strength, the natural oxide layer cannot be removed sufficiently. As a result, there is a disadvantage in that it is impossible to establish a satisfactory contact between the conductive layer and the substrate.

An embodiment of the present invention can provide a method of producing a semiconductor device wherein a gate insulating layer is prevented from being damaged when an etching is performed to remove a natural oxide layer formed on a substrate exposed via a contact hole which is formed in the gate insulating layer.

An embodiment of the present invention can provide a method of producing a semiconductor device wherein a first conductive layer is formed on a gate insulating layer, a contact hole is formed in the first conductive layer and the gate insulating layer, a natural oxide layer formed on an exposed portion of a substrate is removed, and a second conductive layer is formed on the first conductive layer to cover the contact hole. According to this method, the gate insulating layer is protected by the first conductive layer and will not be etched when removing the natural oxide layer by an etching process. For this reason, the gate insulating layer will not be damaged by the etching process as in the case of the conventional method, and it is possible to prevent deterioration of the dielectric strength.

Reference is made, by way of example, to the accompanying drawings, in which:

FIG.1 is a plan view showing an example of a semiconductor device in which a contact is established between a substrate and a gate electrode and wiring formed on the substrate;

FIGS.2A and 2B are views in vertical cross section, showing the semiconductor device of FIG. 1 produced by a conventional method, respectively taken along lines IIA-IIA and IIB-IIB in FIG. 1;

FIGS.3A through 3D are views in vertical cross section respectively showing a semiconductor device at various stages of production, for explaining a method of producing the semiconductor device embodying the present invention;

FIG.4 is a plan view showing a concrete example of the semiconductor device produced by a method embodying the present invention;

FIG.5 is a view in vertical cross section taken along a line V-V in FIG. 4; and

FIG.6 is an equivalent circuit diagram of the semiconductor device shown in FIG.4.

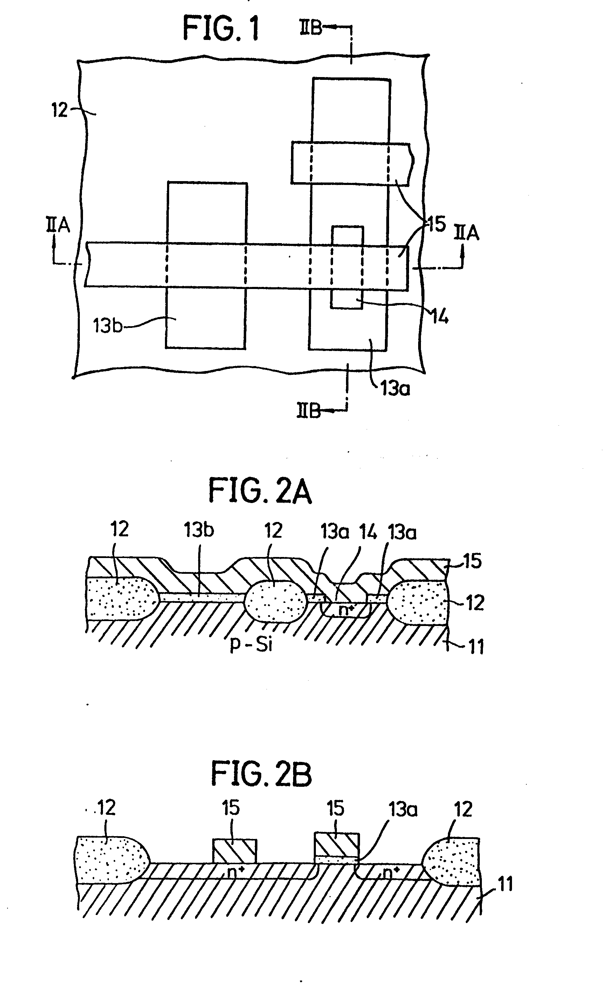

First, description will be given with respect to an example of a conventional method of producing a semiconductor device, by referring to FIGS.1, 2A and 2B.

An oxidation-resistant layer which is formed by patterning is used as a mask to subject a silicon (Si) substrate 11 to a thermal oxidation, and a silicon dioxide ($SiO_2$) layer 12 is formed on an element forming region of the substrate 11 as a field insulating layer for field isolation. Next, $SiO_2$ layers 13a and 13b are formed on the element forming region of the substrate 11 as gate insulating layers.

A contact portion of the $SiO_2$ layer 13a is etched by the usual lithography process, and a contact hole 14 is formed in the $SiO_2$ layer 13a. When performing the etching, the $SiO_2$ layer 13b is covered by a photoresist layer and is protected from the etching. After the photoresist layer is removed, an etching process is performed so as to remove a natural oxide layer formed on the surface of a portion of the substrate 11 exposed via the contact hole 14. Then, a conductive layer 15 is formed on the layers on the substrate 11 to cover the contact hole 14, and a patterning process is thereafter performed to pattern the conductive layer 15 into a gate electrode and wiring.

However, when the etching process is performed to remove the natural oxide layer which is formed on the portion of the substrate 11 exposed within the contact hole 14, the surface of the $SiO_2$ layer 13b which is used as the gate insulating layer is also etched. As a result, the $SiO_2$ layer 13b is damaged by the etching and there is a disadvantage in that the dielectric strength of the $SiO_2$ layer 13b deteriorates as described before. On the other hand, when the etching is not performed extensively so as to prevent the deterioration of the dielectric strength, the natural oxide layer cannot be removed sufficiently, and there is a disadvantage in that it is impossible to establish a satisfactory contact between the conductive layer 15 and the substrate 11 within the contact hole 14.

Accordingly, the present invention is concerned with eliminating or mitigating these disadvantages of the conventional method of producing the semiconductor device. Description will now be given with respect to a method of producing a semiconductor device embodying the present invention.

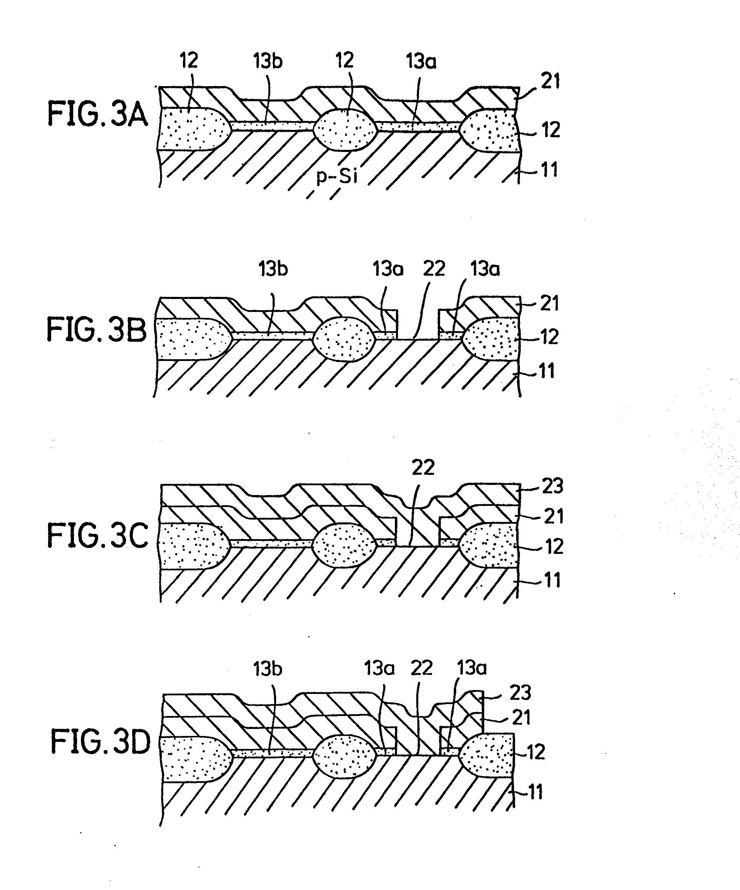

First, in FIG.3A, an oxidation-resistant layer which is formed by patterning is used as a mask to subject the Si substrate 11 to a thermal oxidation, and the $SiO_2$ layer 12 is formed in an element forming region on the substrate 11 as a field insulating layer for field isolation. Next, the $SiO_2$ layers 13a and 13b are formed on the element forming region of the substrate 11 as gate insulating layers, to a film thickness of 200 Å, for example.

As a first conductive layer, a polysilicon layer 21 is formed on the entire surface of the substrate 11 by a chemical vapor deposition (CVD) process. For example, the polysilicon layer 21 has a film thickness of 1000 Å. Next, as shown in FIG.3B, an opening is formed in the polysilicon layer 21 and the $SiO_2$ layer 13a at the contact portion by an etching process so as to form a contact hole 22.

Then, a resist layer (not shown) which is used when forming the contact hole 22 is removed, and an etching process using a fluorine contained etchant is performed to remove a natural oxide layer formed on the surface of a portion of the substrate 11 exposed within the contact hole 22. When this etching process is performed to remove the natural oxide layer, the $SiO_2$ layer 13b will not be damaged because the surface of the $SiO_2$ layer 13b is covered by the polysilicon layer 21.

Accordingly, there is no deterioration of the dielectric strength of the SiO$_2$ layer 13b.

Next, as a second conductive layer, a polysilicon layer 23 is formed on the polysilicon layer 21 to cover the contact hole 22 by a CVD process, as shown in FIG.3C. For example, the polysilicon layer 23 has a film thickness of approximately 3000 Å. Thereafter, as shown in FIG.3D, a patterning process is performed to pattern the polysilicon layers 23 and 21 into a gate electrode and wiring.

According to the method embodying the present invention, the SiO$_2$ layer 13b which constitutes the gate insulating layer is covered by the polysilicon layer 21 which constitutes the first conductive layer in the process shown in FIG.3B. Hence, when the etching process is performed to remove the natural oxide layer, the SiO$_2$ layer 13b will not be damaged by the etching process. As a result, even when the etching process is performed extensively so as to sufficiently remove the natural oxide layer, the dielectric strength of the SiO$_2$ layer 13b will not become deteriorated, and furthermore, it is possible to positively establish a satisfactory contact between the polysilicon layer 23 and the substrate 11 within the contact hole 22.

According to the present embodiment, the SiO$_2$ layers 21 and 23 are used as the first and second conductive layers, but it is possible to use a polysilicon layer for the first conductive layer and a silicide layer for the second conductive layer.

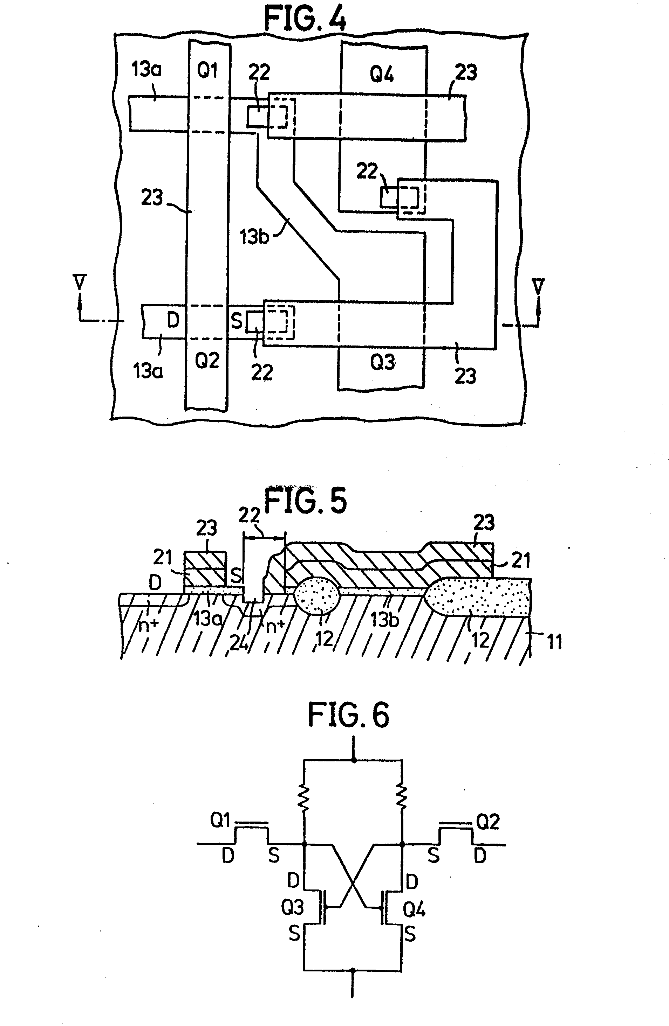

An example of the semiconductor device produced by a method embodying the present invention is shown in FIGS. 4 and 5. FIG.4 shows a part of the semiconductor device including transistors Q1 through Q4, and FIG.6 shows an equivalent circuit diagram of this part of the semiconductor device. In the circuit shown in FIG.6, the source of the transistor Q2 is connected directly to the drain of the transistor Q4, however, in the actual device shown in FIG.4, the source of the transistor Q2 is coupled to the drain of the transistor Q4 via the gate of the transistor Q3. But the circuit shown in FIG.6 is equivalent to the device shown in FIG.4.

In the case where a patterning process is performed to remove unwanted parts of the substrate 11 so that the $SiO_2$ layer 23 remains partially in contact with the substrate 11 within the contact hole 22 (process corresponding to FIG.3D), the patterning process is performed so as to remove the unwanted parts by an amount corresponding to the thickness of the $SiO_2$ layers 21 and 23. For this reason, there is a problem in that a portion 24 within the contact hole 22 is etched off unnecessarily by an amount corresponding to the thickness of the $SiO_2$ layer 21. But this problem can be virtually eliminated by selecting the thickness of the $SiO_2$ layer 21 to a small value in the order of 500 to 1000 $\overset{\circ}{A}$, and no inconvenience is introduced from the practical point of view. In addition, in order to prevent discontinuity of an $n^+$ impurity region at the portion 24, an ion implantation process may be performed with high dose after forming the contact hole 22.

A method of producing a semiconductor device comprises the steps of forming a field insulating layer and at least two gate insulating layers on a semiconductor substrate, where the gate insulating layers are formed at at least two locations on the semiconductor substrate, forming a first conductive layer so as to cover the field insulating layer and the gate insulating layers, patterning the first conductive layer and one of the gate insulating layers so as to form a contact hole in which a surface of the semiconductor substrate is exposed, forming a second conductive layer so as to cover the contact hole and the first conductive layer, and patterning the first and second conductive layers so as to form a gate electrode and wiring extending on another of the gate insulating layers. This other gate insulating layer is protected by the first conductor layer which covers this other gate insulating layer when the contact hole is formed.

CLAIMS

1. A method of producing a semiconductor device comprising the steps of:

forming a field insulating layer and gate insulating layers on a semiconductor substrate, said gate insulating layers being formed at at least two locations on said semiconductor substrate;

forming a first conductive layer so as to cover said field insulating layer and said gate insulating layers;

patterning said first conductive layer and one of said gate insulating layers so as to form a contact hole in which a surface of said semiconductor substrate is exposed;

forming a second conductive layer so as to cover said contact hole and said first conductive layer; and

patterning said first and second conductive layers so as to form a gate electrode and wiring extending on another of said gate insulating layers.

2. A method of producing a semiconductor device as claimed in claim 1 in which said first and second conductive layers are polysilicon layers.

3. A method of producing a semiconductor device as claimed in claim 1 in which said first conductive layer is a polysilicon layer and said second conductive layer is a silicide layer.

4. A method of producing a semiconductor device as claimed in claim 1, 2 or 3 in which said first conductive layer has a thickness within a range of approximately 500 to 1000 Å and said second conductive layer has a thickness of approximately 3000 Å.

5. A method of producing a semiconductor device as claimed in any preceding claim in which the step of patterning to form said contact hole comprises the substeps of:
     patterning to remove said first conductive layer and said one gate insulating layer by use of a resist so as to form said contact hole at a predetermined position; and
     removing a natural oxide layer formed on the surface of said semiconductor substrate exposed within said contact hole by etching,
     said other gate insulating layer being protected by said first conductor layer covering said other gate insulating layer when said natural oxide layer is removed by the etching.

1/3

## FIG.1

## FIG.2A

## FIG.2B

FIG.3A

FIG.3B

FIG.3C

FIG.3D

0209794

# FIG. 4

13a  Q1  22    Q4    23

23

13b

22

D  S

13a  Q2  22    Q3    23

# FIG. 5

22

23    23

21    21

D  S

n+  13a  n+    12  13b    12    11

24

# FIG. 6

Q1
D    S

D
Q3
S

Q2
S    D

D
Q4
S